# EUROPEAN PATENT APPLICATION

(11) **EP 1 306 685 A2**
(43) Date of publication of application: **02.05.2003**
(21) Application number: 02023902.6
(22) Date of filing: 19.12.1997
(51) Int. Cl.: G01R 31/319

(54) **Method and apparatus for performing fully visible tracing of an emulation**

(62) Divisional of application: 97122560.2
(71) Applicant: Mentor Graphics Corporation, Wilsonville, Oregon 97070-7777 (US)
(72) Inventor: Barbier, Jean, 92320 Chatillon (FR); Lepape, Olivier, 75016 Paris (FR); Reblewski, Frederic, 91740 Les Molieres (FR)
(74) Representative: Patentanwälte Leinweber & Zimmermann

(57) **Abstract**

An emulation system is constituted with a plurality of FPGAs having on-chip integrated debugging facilities, distributively disposed on a plurality of circuit boards. Each FPGA's on-chip integrated debugging facilities include in particular, a scan register for outputting trace data, and comparison circuitry for generating inputs for a plurality of system triggers. Correspondingly, each board is provided with a plurality of trace memory for recording the trace data, and summing circuitry for generating partial sums for the triggers. The relative memory location within a clock cycle of trace data where the output of a LE will be recorded is predeterminable. Additionally, a system sync memory is provided for storing a plurality of sync patterns to facilitate reconstitution of trace data of a trace session. Lastly, the compilation or mapping software is enhanced to generate a cross-reference file cross referencing each circuit element in a circuit design to the predeterminable relative memory location within a clock cycle of trace data where the trace data for the particular circuit element can be found.
Together, these elements allow fully visible tracing to be performed for an emulation.

## Description

### BACKGROUND OF THE INVENTION

### 1. Field of the Invention

The present invention relates to the field of emulation systems. More specifically, the present invention relates to methods and apparatus for performing tracing of an emulation.

### 2. Background Information

Emulation systems for emulating circuit design are known in the art. Typically, prior art emulation systems are formed using conventional general purpose field programmable gate arrays (FPGAs). A circuit design to be emulated is "realized" on the emulation system by compiling a "formal" description of the circuit design, and mapping the circuit design onto the logic elements (LEs) of the FPGAs.

Conventional general purpose FPGAs, as far as their applications to emulation systems are concerned, have at least three disadvantages. First of all, the states of signals at the nodes mapped inside the FPGAs are not observable, thus the term "hidden" nodes. Secondly, in order to be able to observe the states of signals at these "hidden" nodes, reconfiguration, and therefore extremely time consuming recompilation is required to bring these signals outside the FPGAs to a logic analyzer. Thirdly, a number of FPGA I/Os have to be consumed for bringing these signals to the outside logic analyzer. Furthermore, the additional signals to be routed further increase signal routing congestion. Finally, for timing sensitive applications, it is difficult to know whether the signals at these "hidden" nodes were read at precisely the correct time or not, if the signals are to be read in response to the occurrence of certain events, since the signals have to be brought out of the FPGAs before the read triggering events can be detected.

Thus, it is desirable to have an emulation system and methodology for operating therein for performing fully visible tracing of an emulation. As will be described in more detail below, the present invention provides for such emulation system that achieves these and other desired results, which will be apparent to those skilled in the art from the description to follow.

### SUMMARY OF THE INVENTION

An improved emulation system and methodology for operating therein for performing fully visible tracing is disclosed. The improved emulation system is constituted with a plurality of improved FPGAs having on-chip integrated debugging facilities, distributively disposed on a plurality of circuit boards (For the purpose of this application, the terms circuit boards and logic boards are synonosmous.) incorporated with the teachings of the present invention. More specifically, each FPGA's on-chip integrated debugging facilities include in particular, a scan register for outputting trace data for the LEs inside the FPGA, on a clock cycle by clock cycle basis, making the LEs fully visible from outside the FPGA, and comparison circuitry for generating trigger inputs for a number of system triggers in response to the detection of certain pre-stored data patterns.

Correspondingly, under the presently preferred embodiment, each circuit board is provided with a plurality of trace memory, one per FPGA, for recording the trace data output by the FPGAs, and summing circuitry, one per system trigger, for generating partial sums of the trigger inputs output by the FPGAs. The on-board trace memory is designed to facilitate recordation of trace data with a deterministic locality topology. In other words, the relative memory location within a clock cycle of trace data where the output of a LE of a particular FPGA will be recorded is predeterminable. Each circuit board is also provided with an address counter for generating addresses for the on-board trace memory.

Additionally, a number of system triggers are provided to generate a number of trigger signals using the partial sums output by the on-board summing circuitry, and a system synchronization memory is provided for synchronously recording sync patterns to facilitate recording of trace data in the on-board trace memory in a "wrap around" manner. A system address counter is also provided for generating addresses for the system synchronization memory. The compilation/mapping software is also enhanced to generate a cross-reference file of cross reference records cross referencing the circuit elements of a circuit design to be emulated to the predeterminable memory locations wherein the trace data for the circuit elements are to be found.

During compilation/mapping, the cross reference file is generated and saved. Then, during operation, the on-board address counters and the system address counter are reset each time a reset signal is asserted, such as at the beginning of an emulation. Upon detection of a monitored event by a trigger, signal state values of the LEs of the various FPGAs are caused to be scanned out and stored into the on-board trace memory. At the same time, sync patterns are synchronously stored into the system sync memory. During post processing, the sync patterns are used to reconstitute the trace data of a "trace session", whereas the cross reference records are used to retrieve trace data of specific circuit elements.

### BRIEF DESCRIPTION OF DRAWINGS

The present invention will be described by way of exemplary embodiments, but not limitations, illustrated in the accompanying drawings in which like references denote similar elements, and in which:
**Figure 1** illustrates an exemplary emulation system incorporated with the teachings of the present invention;
**Figure 2** is a physical view of one embodiment of the emulator of **Fig. 1;**
**Figure 3** illustrates one embodiment of the logic board of **Fig. 2**;
**Figures 4a - 4b** illustrate one embodiment of the FPGA array of **Fig. 3**;
**Figure 5** illustrates one embodiment of the inter-FPGA crossbar network (stage 1) of **Fig. 3**;
**Figure 6** illustrates one embodiment of the on-board summing circuitry of **Fig. 3**;
**Figure 7** illustrates one embodiment of the on-board trace memory of **Fig. 3**, and system sync memory of **Fig. 8**;
**Figure 8** illustrates one embodiment of the backplane of **Fig. 2**;
**Figure 9** illustrates one embodiment of the inter-board crossbar network (stage 1) of **Fig. 8**;
**Figure 10** is an exemplary timing diagram illustrating the manner in which trace data of the LEs of a FPGA are caused to be output;
**Figure 11** illustrates one embodiment of the circuit design compilation/mapping software of **Fig. 1**; and
**Figure 12** illustrates one embodiment of the cross reference file of **Fig. 11**.

### DETAILED DESCRIPTION OF THE INVENTION

In the following description, for purposes of explanation, specific numbers, materials and configurations are set forth in order to provide a thorough understanding of the present invention. However, it will be apparent to one skilled in the art that the present invention may be practiced without the specific details. In other instances, well known features are omitted or simplified in order not to obscure the present invention.

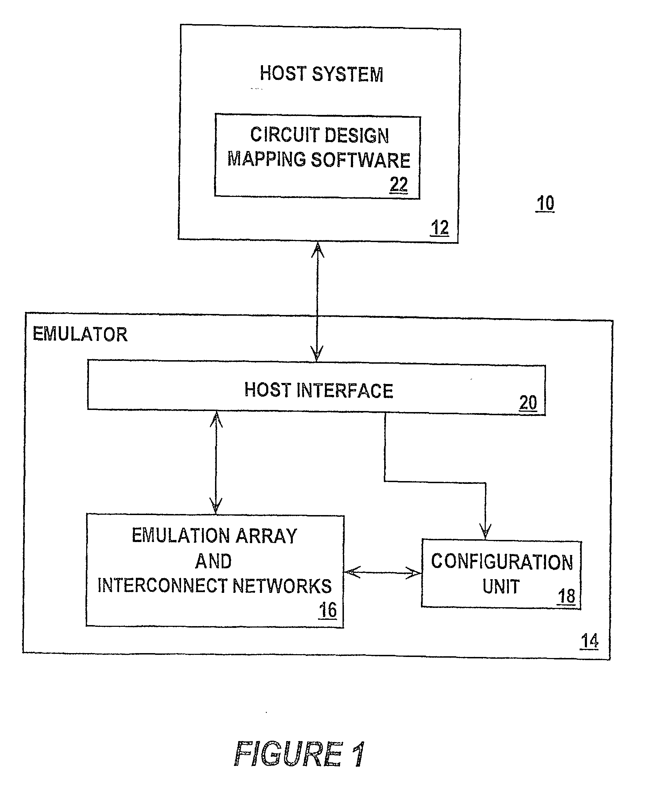

Referring now to **Figure 1**, an emulation system **10** incorporated with the teachings of the present invention is shown. As illustrated, emulation system **10** includes host system **12** and emulator **14.** Host system **12** includes in particular enhanced circuit design compilation/mapping software **22.** Circuit design compilation/mapping software **22** are stored in suitable storage medium (not shown) of host system **12,** and loaded into memory (not shown) of host system **12** for execution by one or more processors (not shown) of host system **12.** Except for the enhancement provided to circuit design compilation/mapping software **22,** host system **12** including circuit design compilation/mapping software **22** is intended to represent a broad category of host systems and their software found in conventional emulation systems, thus will not be otherwise further described.

Emulator **14** includes emulation array and interconnecting networks **16** incorporated with the teachings of the present invention, configuration unit **18** and host interface **20** coupled to each other as shown. Except for emulation array and interconnecting network **16,** configuration unit **18** and host interface **20** are also intended to represent a broad category of these elements found in conventional emulators, whose functions and constitutions are also well known, and therefore will not be further described either.

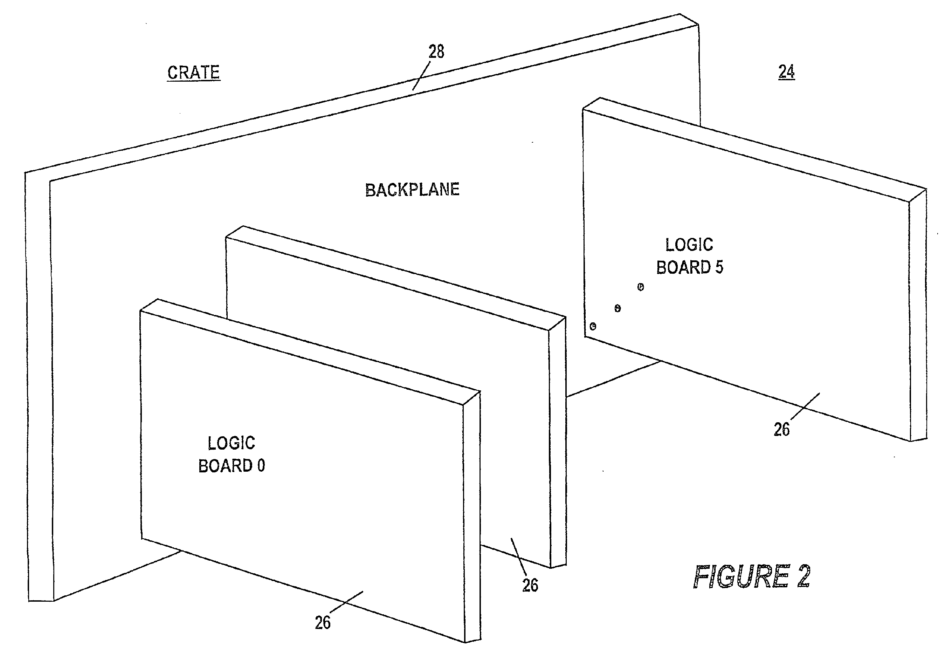

Referring now to **Figure 2**, wherein a physical view of one embodiment of emulation array and interconnect networks **16** is shown. For the illustrated embodiment, emulation array and interconnect networks **16** is distributively disposed on a plurality of logic boards **26.** Logic boards **26** are electrically connected to each other through backplane **28.** Together, logic boards **26** and backplane **28** are packaged in crate **24.** Before we proceed to describe logic boards **26** and backplane **28** in further detail, it should be noted that while for ease of explanation, the present invention is being described with a single crate embodiment, based on the description to follow, a person skilled in the art will appreciate that the present invention may be practiced in any number of form factors comprising any number of "crates" with each "crate" having any number of "logic boards" directly connected to each other or indirectly connected to each other via one or more "backplanes".

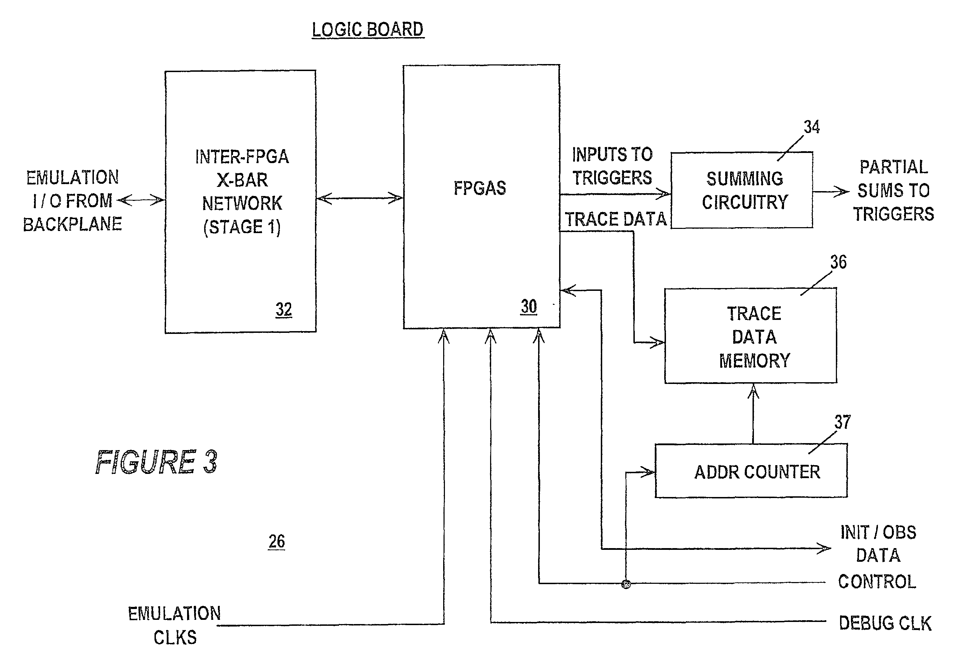

**Figure 3** illustrates one embodiment of logic board **26.** As shown, for the illustrated embodiment, each logic board **26** comprises a plurality of FPGA **30** for "realizing" the circuit elements of a circuit design. In other words, FPGAs **30** of emulation array **16** are distributively disposed on one or more logic boards **26.** Additionally, each logic board **26** further comprises inter-FPGA crossbar (or x-bar) network (stage 1) **32** coupled to FPGAs **30** for interconnecting FPGAs **30** on the various logic boards **26** to each other and to host system **12.** Furthermore, logic board **26** comprises trace data memory **36,** and summing circuitry **34**, both coupled to FPGAs **30,** for capturing and storing fully visible LE trace data of FPGAs **30** and generating partial sums for trigger inputs output by FPGA **30.** Logic boards **26** is also provided with address counter **37** for generating addresses for trace data memory **36.**

In accordance to the present invention, each FPGA of FPGAs **30** is to include on-chip integrated debugging facilities. In particular, each FPGA is to include a first integrated debugging facility for outputting fully visible trace data of all its LEs, on a clock cycle by clock basis, and a second integrated debugging facility for outputting inputs for a plurality of system triggers. A particular example of a FPGA having such on-chip integrated debugging facilities is disclosed in copending European Patent Application No. .......... , entitled "A field programmable gate array with integrated debugging facility", having common inventorship and applicant with the present invention, and filed contemporaneously with this application, which is hereby fully incorporated by reference. Nevertheless, we will be briefly describe the FPGA disclosed in the copending application further below.

Inter-FPGA crossbar network (stage 1) **32** comprises a plurality of programmable electrical signal switching paths. Inter-FPGA crossbar network (stage 1) **32,** also functionally "doubles" as inter-board crossbar network (stage 0) for interconnecting logic boards **26,** to be described more fully below. A particular example of inter-FPGA cross network (stage 1) **32** will also be briefly described below.

On-board trace data memory **36** in accordance to the present invention facilitates capturing and storing trace data output by FPGAs **30,** i.e., signal state values of the LEs of FPGAs **30,** with a deterministic locality topology. In other words, the relative memory location within a clock cycle of trace data where the output of a LE of a particular FPGA is to be recorded is pre-determinable. Trace data memory **36** is advantageously placed on-board close to FPGAs **30** to ensure all signal state values of all LEs of a FPGA can be captured and stored within a clock cycle of an emulation clock, without having to slow down the emulation clock to accomplish the clock cycle by clock cycle objective (In many emulations, the option of "slowing down" the emulation clock is not even available, since the design is to be emulated in the target operating speed.). In the presently preferred embodiment, one trace data memory unit is provided for each FPGA. The trace data memory units **36** and the FPGAs **30** are correspondingly coupled to each other. Moreover, fast dual ported video random access memory (RAM) are used for trace data memory **36** to further facilitate achieving the objective of being able to capture and store the trace data of all LEs on a clock cycle by clock cycle basis.

On-board address counter **37** is provided for generating addresses for on-board trace memory **36.** On-board address counter **37** is incremented using the same scan clock employed for scanning out the trace data of all LEs of FPGAs **30,** on a clock cycle by clock cycle basis, to be more fully described below. While functionally, one "global" address counter is sufficient, however, one address counter **37** per logic board **26** is preferred, in order to eliminate having to route the trace memory addresses to each logic board **26**, thereby reducing the pin out requirements on each logic board **26.**

On-board summing circuitry **34** comprises a plurality of partial sum circuits. In the presently preferred embodiment, one summing circuit is provided for each system trigger, and all FPGAs **30** are coupled to each of the summing circuits **34.**

Trace data memory **36** and summing circuitry **34** will be described in more detail below with references to the additional figures. However, we will first briefly describe the FPGA and the relevant aspect of interconnecting FPGAs.

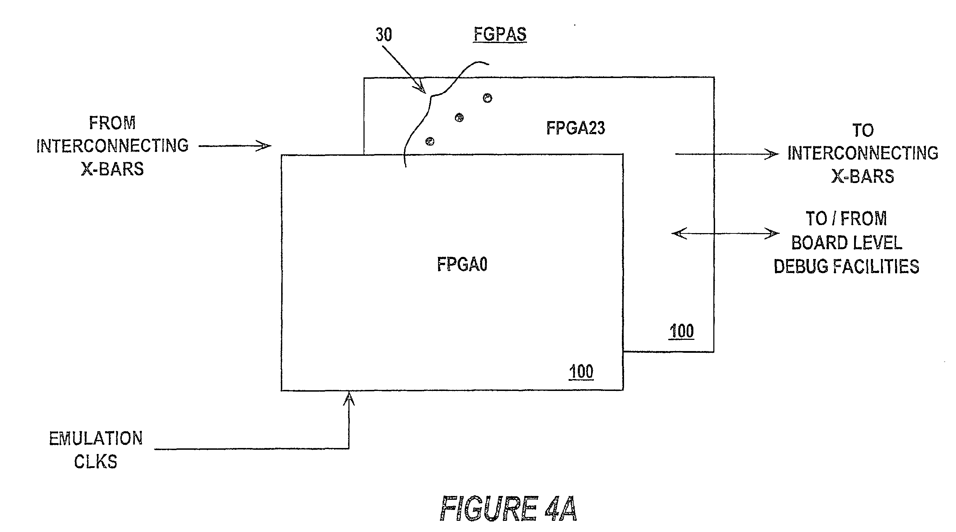

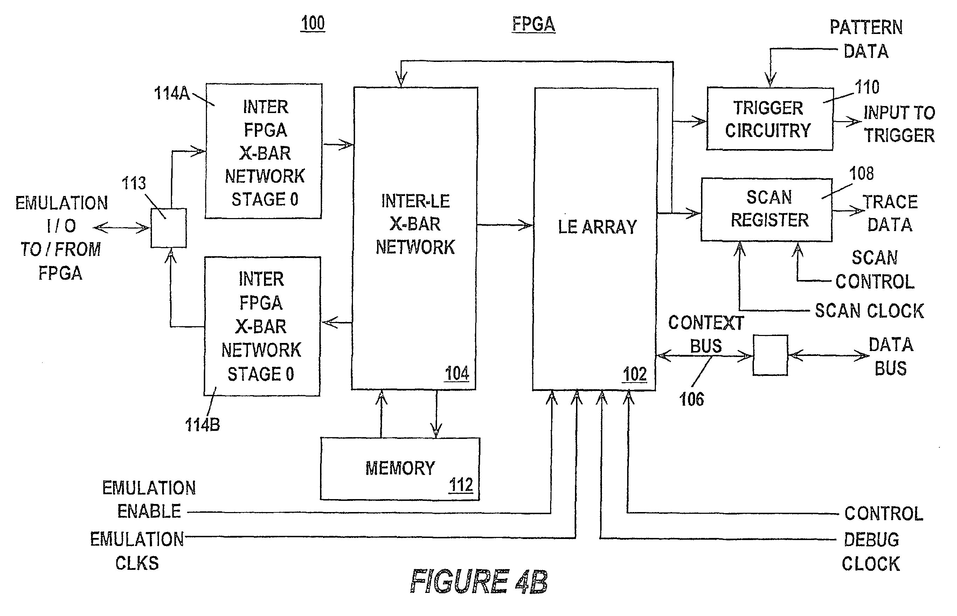

**Figures 4a-4b** illustrate one embodiment of FPGAs **30** disclosed in the copending application. As shown, for the illustrated embodiment, FPGAs **30** comprise 24 FPGAs with on-chip integrated debugging facilities **100.** FPGA **100** comprises an array **102** of enhanced LEs, which are used to "realize" various elements of circuit designs. Additionally, FPGA **100** further includes context bus **106,** scan register 108 and trigger circuitry **110,** coupled to the enhanced LEs as shown. Context bus **106** is used for inputting and outputting values to and from the LEs. Scan register **108** is used to output trace data of all LEs of a FPGA in one clock cycle of an emulation clock, whereas trigger circuitry **110** is used to generating a number of trigger inputs in response to the detection of a number of stored data patterns.

For the illustrated embodiment, FPGA **100** further includes memory **112** to facilitate usage of FPGA **100** for emulating circuit designs with memory. Pins **113** of FPGA **100** can be preconfigured for either input or output. FPGA **100** also includes inter-LE crossbar network **104** for interconnecting the LEs **102,** memory **112,** and I/O pins **113,** as shown. Finally, FPGA **100** also include the inter-FPGA crossbar network (stage 0) **114** for inter-connecting FPGA **100** to other FPGAs. Inter-FPGA cross-bar network (stage 0) **114** at the chip-level "mates" with inter-FPGA cross-bar network (stage 1) **32** at the board level.

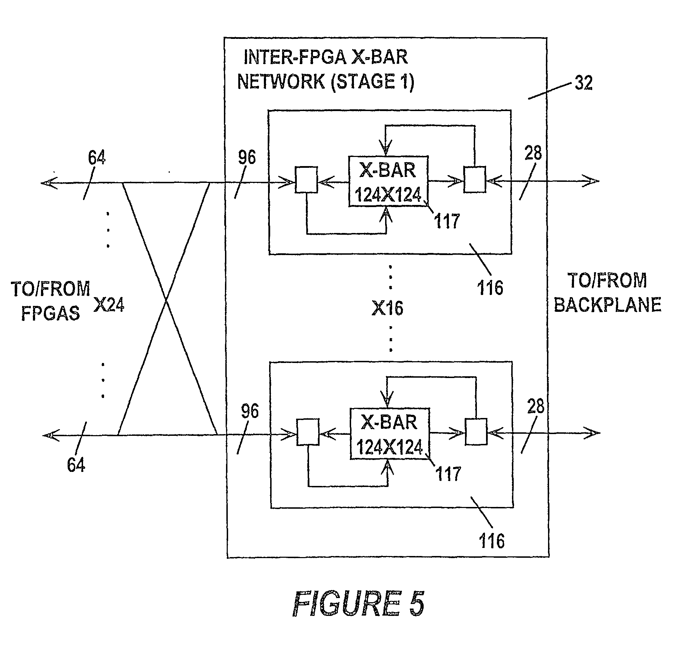

**Figure 5** illustrates one embodiment of inter-FPGA crossbar network (stage 1) **32** disclosed in the above identified copending application. As shown, for the illustrated embodiment, inter-FPGA crossbar network (stage 1) **32** comprises 16 routing chips **116** for coupling 64 I/O signals from each of 24 FPGAs **30** to the next stage of a Claus network for interconnecting the FPGAs to each other. In other words, full cross switching between the 64 I/O pins of each FPGA and the 448 I/O pins of logic board **26** is provided. Each of routing chips **116** comprises a 124 x 124 crossbar **117** to facilitate routing of 96 signals to/from FPGA **30** and 28 signal to/from backplane **28.**

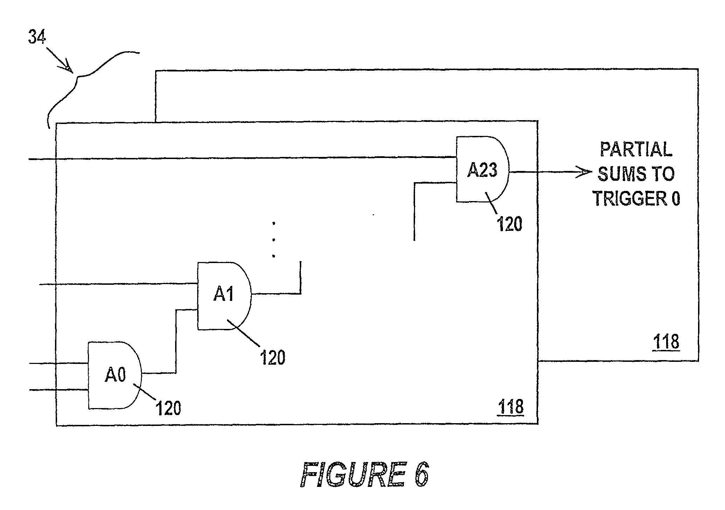

Referring now to **Figure 6**, wherein one embodiment of on-board summing circuitry **34** is illustrated. As shown, for the illustrated embodiment, on-board summing circuitry **34** comprises four sets of AND gates **118.** In other words, for the illustrated embodiment, partial sum inputs are generated for 4 system triggers. Each set **118** comprises 24 AND gates, serially coupled to each other and corresponding coupled to 24 FPGAs **30.** Each set **118** receives the trigger inputs output by the corresponding FPGAs **30** and in response, the received inputs are incrementally aggregated to generate a partial sum input for all 24 FPGAs **30** for a system trigger. The system trigger may be used for a variety of purposes, including in particular, the starting of trace data collection.

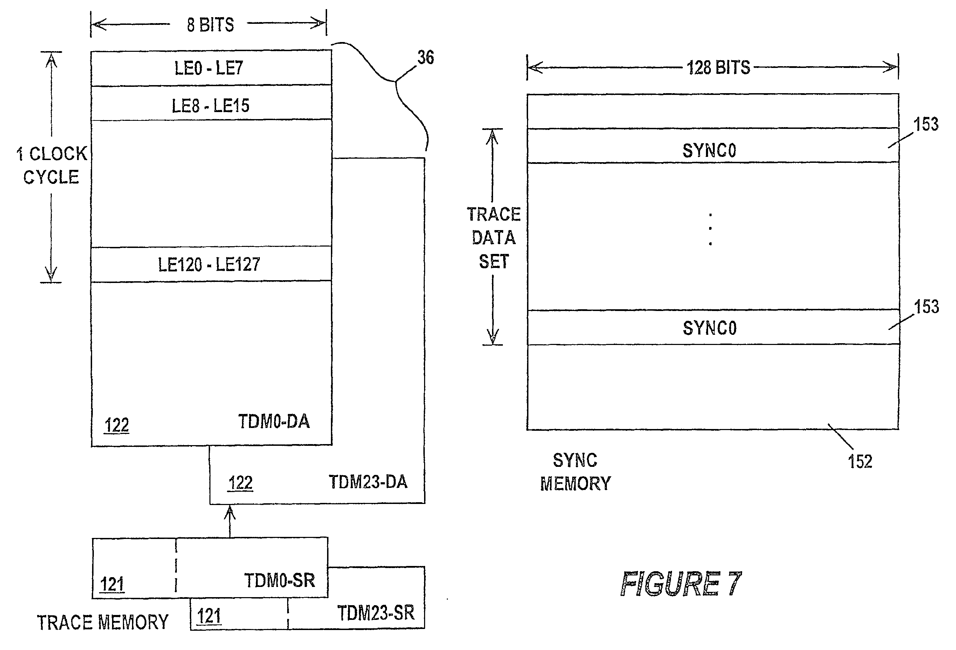

Referring now to **Figure 7,** wherein one embodiment of on-board trace memory **36** is illustrated. **Figure 7** also illustrates system sync memory **152** whose description will be deferred until backplane **28** has been described. As shown, for the illustrated embodiment, trace memory **36** comprises 24 memory units, i.e. one per FPGA of FPGAs **30.** As described earlier, each memory unit is preferably implemented using fast dual-port video RAM comprising a RAM array portion **122,** and a shift register portion **121.** Preferably, each half of shift register **121** can be operated on independently of the other half, allowing the two halves to be independently loaded into the corresponding RAM array **122** as soon as it is filled, without having to wait for the filling of the other half to be completed. For the illustrated embodiment, on-board trace memory unit **122** is 8-bit wide. Thus, for an embodiment wherein the FPGA comprises 128 LEs, 16 bytes (16x8=128) are used to store the trace data output by a FPGA per clock cycle. Therefore, the precise memory location where the trace data of a LE will be written in trace memory **36** is predeterminable. As a result, once the decision is made as to the mapping of a particular circuit element of a circuit design to be emulated, the relative memory location within a clock cycle of trace data where the output of the particular circuit will be written is known.

Under the presently preferred embodiment, trace data are stored in trace memory **36** from "top" to the "bottom". Once the "bottom" of trace memory **36** is reached, storage of trace data starts from the "top" again. In other words, trace memory **36** is accessed as a "wrap around" buffer. As will be described in more detail below, sync patterns synchronously stored in a system sync memory **152** is used to reconstitute the trace data of a "trace session" during post processing.

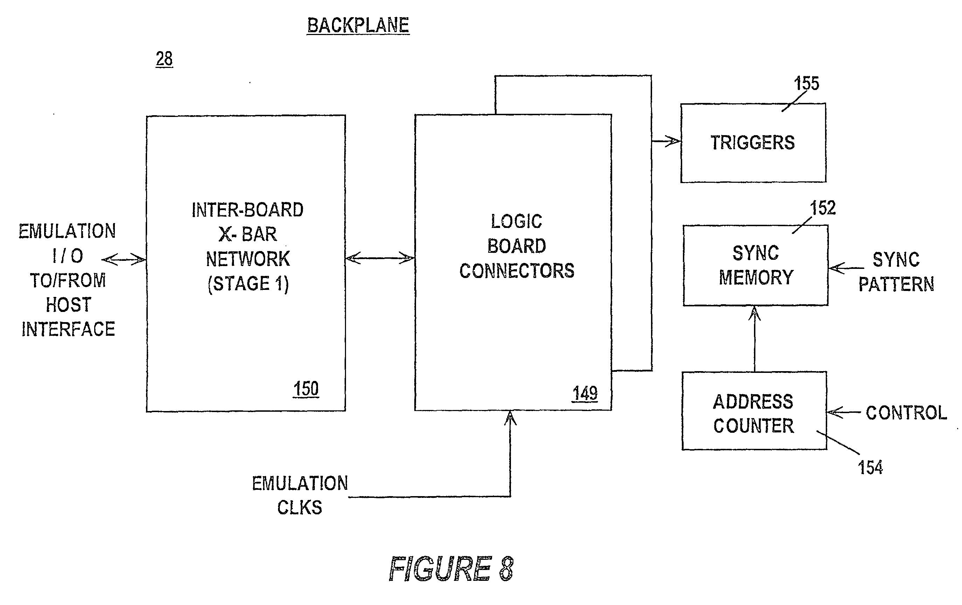

Having now described the major components at the board level. We now proceed to describe how the boards are electrically coupled to each together. Recall from **Fig. 2** that multiple logic boards **26** are physically and electrically coupled to backplane **28** to form crate **24. Figure 8** illustrates one embodiment of backplane **28.** In addition to logic board connectors **149** for receiving logic boards **26,** backplane **28** further comprises inter-board crossbar network (stage 1) **150** for electrically interconnecting logic boards **26.** Functionally, inter-board crossbar network (stage 1) **150** can also be considered as inter-FPGA crossbar network (stage 2). (For multi-crate embodiments, it also "doubles" as inter-crate crossbar network stage 0.)

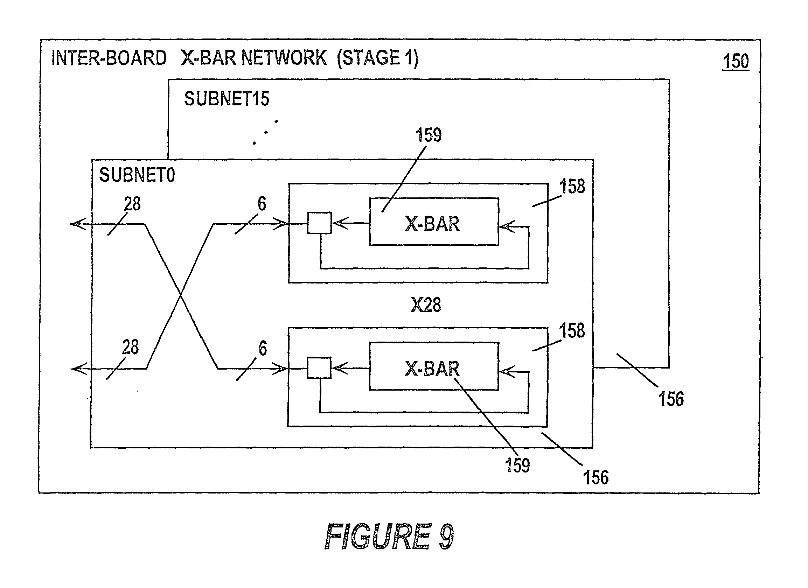

**Figure 9** illustrates one embodiment of inter-board crossbar network (stage 1) **150.** As shown, for the illustrated embodiment, inter-board crossbar network (stage 1) **150** comprises 16 subnets, subnet0 through subnet15 **156.** Each subnet **156** comprises 28 routing chips **156** for interconnecting 6 sets of 28 signals output by FPGAs **30** at the board level in a "butterfly" manner, one set per logic board **26.** Each routing chips **156** comprises a 6 x 6 crossbar **159** for providing routing of 6 signals to/from logic boards **26** (Some or all of routing chips **158** may be combined together, in particular, for "larger" embodiments.). In other words, only the outputs of the correspondingly disposed routing chips **116** in inter-FPGA crossbar network (stage 1) **32** on various logic boards **26** are interconnected together. For examples, the "first" routing chip **116** in inter-FPGA crossbar network (stage 1) **32** on the six logic boards **26** are interconnected together, the "second" routing chip **116** in inter-FPGA crossbar network (stage 1) **32** on the six logic boards **26** are interconnected together, and so forth.

Referring back to **Figure 8,** backplane **28** further comprises a number of system triggers **155**, system sync memory **152,** and system address counter **154.** Each system trigger **155** receives a partial sum output from each of logic boards **26,** and in response, triggers a global signal if the at least one of the received partial sums is in a desired state. As described earlier, sync memory **152** is used to synchronously store sync patterns as trace data are output from FPGAs **30** and stored into on-board trace memory **36.** System address counter **154** is used to generate addresses for sync memory **152.** Address counter **154** is incremented proportionally using the same scan clock for scanning out trace data and incrementing on-board address counters **37** described earlier. For example, in one embodiment, system address counter **154** is incremented once for each clock cycle, while on-board address counters **37** are incremented 16 times for each clock cycle. While triggers **155,** sync memory **152** and address counter **154** are being described as disposed on backplane **28**, as will be appreciated by those skilled in the art, they may be disposed in a number of alternative locations, for example, a common control or service board.

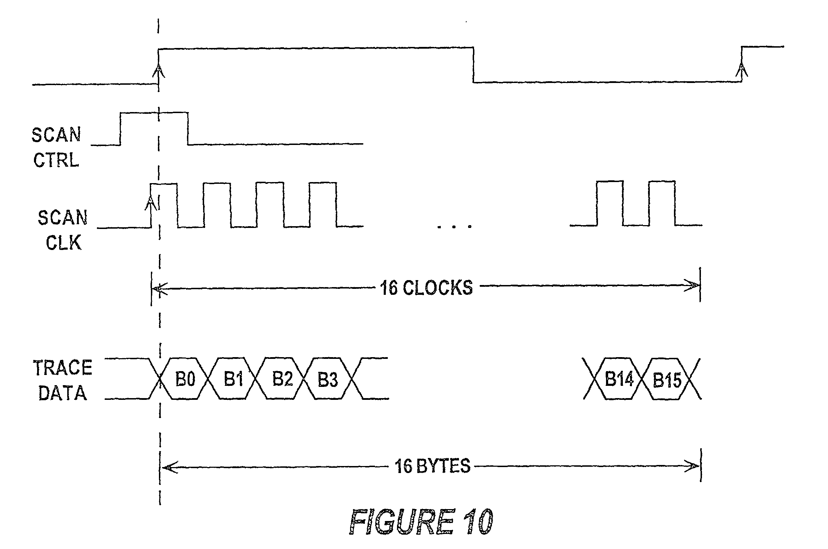

Before describing system sync memory **152** more fully, refer now briefly to **Figure 10,** wherein an exemplary timing diagram for causing trace data to be scanned out of LE array **102** of FPGA **100** is shown. As shown, at the rising edge of the current operating emulation clock, a scan control signal and a number of scan clock pulses are provided by host system **10** to scan register **108** causing scan register **108** to serially scan out the current values of the LEs of LE array **102**. If trace data are collected in response to the detection of certain events, the scan control signal and scan clock pulses are provided in response to the trigger signals generated as a result of the detection of prestored data patterns representing the events. The number of clock pulses to be provided are determined by the number of internal elements of scan register **108.** In an embodiment where scan register **108** comprises 16 sets of 8 flip-flops with each set responsible for 8 LEs, 16 clock signals are provided as shown. The required clock pulses are provided in-between two rising edges of the operating emulation clock, to ensure all LE trace data are scanned out within one clock cycle, thereby allowing fully visible LE trace data to be captured in a clock cycle by clock cycle basis. In response, as illustrated, for the 16 flip-flop set embodiment, 16 bytes of trace data are written into the trace memory unit of trace memory **36** corresponding to the particular FPGA **100.**

Referring now to **Figure 7** again, as the trace data are scanned out of FPGAs **30**, the trace data are shifted into the corresponding shift registers **121** of trace memory **36**. Whenever the left or right halves of shift registers **121** are filled, the stored trace data are stored into the corresponding memory locations of trace memory **36** denoted by on-board address counter **37.** Concurrently, a sync pattern **153** is stored into a corresponding memory location of system sync memory **152** denoted by system address counter **154**. In one embodiment, sync pattern **153** is the same size as one clock cycle for trace data, e.g. 128 bits for the 128 LE FPGA embodiment. The same sync pattern is used for all trace data collected in a "trace session". Thus, during post processing, starting at memory locations in all on-board trace memory **36** corresponding to where address counter **154** stopped, the trace data of a "trace session" can be reconstituted by reading proportionally "backward" in all on-board trace memory **36**, as long as corresponding "backward" reading of sync patterns **153** stored in sync memory **152** remain unchanged.

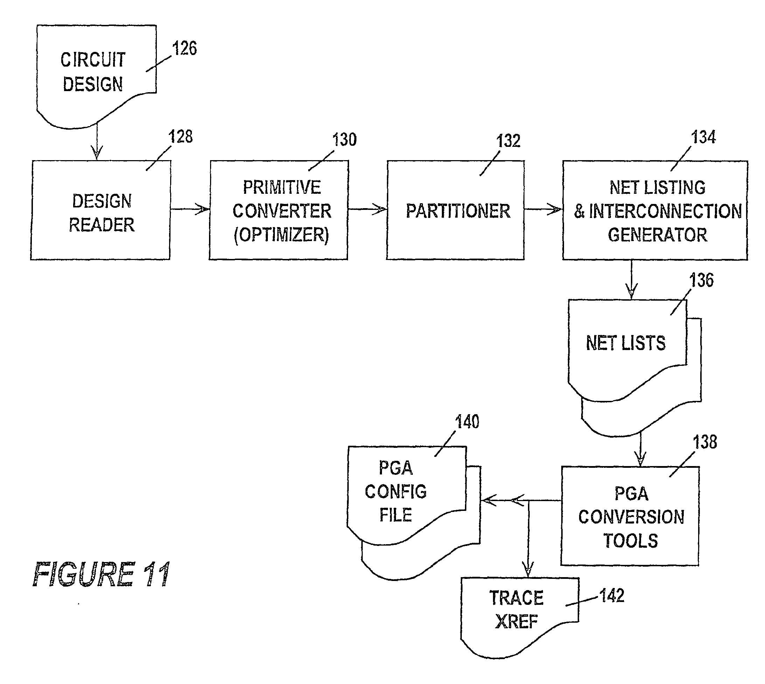

Having now described the operating method for collecting the fully visible trace data, and the manner in which the trace data of a "trace session" can be reconstituted, we now proceed to describe how the trace data can be correlated with the various circuit elements of the circuit design being emulated. Recall from earlier description, host system **12** includes circuit design compilation/mapping software (see **Fig.1**) for compiling and mapping the circuit design to the LEs of FPGAs **30,** and the memory locations where the state values of the LEs will be written are predeterminable (see **Fig. 7**). **Figure 11** illustrates one embodiment of circuit design compilation/mapping software **22** enhanced to leverage the deterministic characteristic of the LE trace data storage locations . As shown, circuit design compilation/mapping software **22** comprises design reader **128,** primitive converter **130**, partitioner **132**, and net listing and interconnection generator **134** for reading, interpreting, optimizing, and partitioning circuit design **124** into net lists **136.** Circuit design compilation/mapping software **22** further comprises PGA configuration tools **138** for converting net lists **136** into PGA conversion files **140**, which are then used to configure emulator **14** to "realize" circuit design **126** on emulator **14.** Additionally, in accordance to the present invention, PGA conversion tools **138** are enhanced to also generate cross reference file **142** for cross referencing circuit elements of circuit design **126** to memory locations of trace memory **36.**

Except for the generation of cross reference file **142,** design reader **128,** primitive converter **130** etc. of circuit design compilation/mapping software **22** are intended to represent a broad category of these software tools found in conventional emulation systems, thus will not be further described.

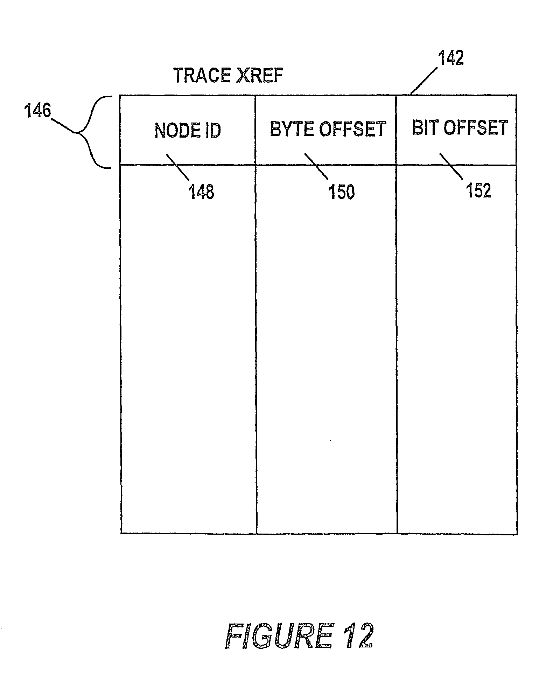

**Figure 12** illustrates one embodiment of cross reference file **142.** As shown, cross reference file **142** comprises cross reference records **146** for circuit elements of circuit design **126.** Each cross reference record **146** comprises a node identifier **148** identifying the circuit element, a byte offset **150** identifying the offset location into each group of trace data (for a clock cycle) where the trace data for the particular circuit element is to be found, and a bit offset **152** identifying the offset location into the identified byte position where the trace data for the particular circuit element is located.

Thus, when an emulator system is equipped with FPGA having on-chip integrated facilities, which in turn are complemented with trace memory with the above described deterministic characteristics, fully visible tracing may be performed employing the cross references and sync patterns as described above. Therefore, a method and apparatus for performing fully visible tracing of an emulation has been described.

While the method and apparatus of the present invention has been described in terms of the above illustrated embodiments, those skilled in the art will recognize that the invention is not limited to the embodiments described. The present invention can be practiced with modification and alteration within the spirit and scope of the appended claims. The description is thus to be regarded as illustrative instead of restrictive on the present invention.

## Claims

1. An apparatus comprising:
a plurality of field programmable gate arrays (FPGAs) (30) to emulate at least a subset of a circuit design, each field programmable gate array (30) being a single integrated circuit comprising both a plurality of logic elements (LEs) (102) to realize circuit elements of the at least a subset of the circuit design and a first on-chip integrated debugging facility to output a predetermined number of signal state values from the LEs (102) on a clock cycle by clock cycle basis; and
a memory coupled to the FPGAs (30) comprising a first plurality of memory locations (122) to capture and store the LE signal state values, a second plurality of memory locations (152) synchronized to the first plurality of memory locations (122) to store synchronization patterns (153) as the LE signal state values are stored, and a third plurality of memory locations to store a cross reference file (142), said cross reference file to predetermine a relative memory location within a clock cycle worth of stored LE signal state values where a signal state value of a particular circuit element is stored.

2. The apparatus of claim 1 wherein the memory comprises a trace memory (36) to store the first and third pluralities of memory locations; and a synchronization memory (152) to store the second plurality of memory locations.

3. The apparatus as set forth in claim 2, wherein the trace memory (36) comprises a plurality of trace memory units (121, 122) correspondingly coupled to the FPGAs (30), each trace memory unit comprises memory locations for storing N clock cycles of LE signal state values, and the signal state value of a LE is stored in a predetermined fixed offset into each block of memory locations used for storing a clock cycle of LE signal state values.

4. The apparatus as set forth in claim 3, wherein the apparatus further comprises an address counter (37) coupled to the trace memory units for generating addresses for the trace memory units in a manner coordinated with the outputting of the LE signal state values.

5. The apparatus as set forth in anyone of claims 1 to 4, wherein
each FPGA (30) further comprises a second on-chip integrated debugging facility (110) for outputting the LE signal state values as inputs to at least one trigger; and
the apparatus further comprises at least one summing circuit (34) coupled to the FPGAs (30) for generating a partial sum of the LE signal state values for each of the at least one trigger.

6. The apparatus as set forth in any of claims 2 to 5, wherein
the FPGAs (30) are distributively disposed in a plurality of logic boards (26), and
the trace memory comprises a plurality of trace memory units being correspondingly coupled to the FPGAs (30), one trace memory unit per FPGA, and disposed on the same logic board with the coupled FPGA.

7. The apparatus as set forth in claim 6, wherein each trace memory unit comprises memory locations for storing N clock cycles of LE signal state values, and the signal state value of a LE is stored in a predetermined fixed offset into each block of memory locations for storing a clock cycle of LE signal state values.

8. The apparatus as set forth in anyone of claims 6 or 7, wherein the apparatus further comprises a plurality of address counters correspondingly disposed on the logic boards and coupled to the trace memory units of the same logic board for locally generating addresses for the local trace memory units in a manner coordinated with the outputting of the LE signal state values.

9. The apparatus as set forth in anyone of claims 6 to 8, wherein the trace data are stored into the trace memory units in a wrap around manner.

10. The apparatus as set forth in anyone of claims 2 to 9, wherein
the FPGAs (30) are distributively disposed in a plurality of logic boards (26),
the summing circuitry (34) comprises a plurality of at least one partial sum circuit distributively disposed on the logic boards (26) and coupled to the FPGAs on the same logic board for generating a plurality of partial sums of the LE signal state values for the at least one trigger.

11. A method comprising:
receiving logic element (LE) signal state values on a clock cycle by clock cycle basis from a plurality of field programmable gate arrays (FPGA) (30), said plurality of FPGAs to emulate at least a subset of a circuit design, each field programmable gate array being a single integrated circuit comprising both a plurality of LEs (102) to realize circuit elements of the at least a subset of the circuit design and a first on-chip integrated debugging facility to output a predetermined number of signal state values from the LEs (102) on a clock cycle by clock cycle basis;
storing the LE signal state values in a first plurality of memory locations (122);
storing synchronization patterns (153) in a second plurality of memory locations (152) as the LE signal state values are stored, said second plurality of memory locations being synchronized to the first plurality of memory locations; and
storing a cross reference file (142) in a third plurality of memory locations, said cross reference file to predetermine a relative memory location within a clock cycle worth of stored signal state values where a signal state value of a particular circuit element is stored.

12. The method as set forth in claim 11, wherein the FPGAs (30) are distributively disposed in a plurality of logic boards (26), said LE signal state values being stored in a plurality of trace memory units correspondingly coupled to the FPGAs and disposed in the same logic board as the coupled FPGA.

13. The method as set forth in claim 12, wherein the method further comprises generating trace memory addresses on each logic board (26) locally and providing the locally generated trace memory addresses to the trace memory units of the corresponding logic boards.

14. The method as set forth in anyone of claims 12 or 13, wherein the method further comprises storing the signal state value of a LE in the same relative offset location within a block of memory locations used for storing the LE state values output for a clock cycle.

15. The method as set forth in anyone of claims 13 to 14, wherein the method further comprises storing said LE signal state values into the trace memory units in a wrap around manner.

16. The method as set forth in anyone of claims 11 to 15, wherein the cross reference file (142) comprises a plurality of cross reference records (146), each cross reference record having identification information of a circuit element, and one or more offset values into each block of memory locations for storing a clock cycle of LE signal state values where the signal state value of the LE onto the circuit element is mapped is stored.
